(19) Europäisches Patentamt

European Patent Office

Office européen des brevets

(11) **EP 0 566 398 B1**

(12) **EUROPEAN PATENT SPECIFICATION**

(45) Date of publication and mention
of the grant of the patent:
**19.06.2002 Bulletin 2002/25**

(51) Int Cl.[7]: **G04F 10/00**, G04G 3/02

(21) Application number: **93302913.4**

(22) Date of filing: **15.04.1993**

(54) **A digital trimming circuit**

Digitale Trimmschaltung

Circuit d'ajustage numérique

(84) Designated Contracting States:
**CH DE FR GB LI**

(30) Priority: **17.04.1992 JP 9788892**
**14.05.1992 JP 12215492**
**22.02.1993 JP 3178393**

(43) Date of publication of application:
**20.10.1993 Bulletin 1993/42**

(73) Proprietor: **SEIKO EPSON CORPORATION**
**Shinjuku-ku Tokyo (JP)**

(72) Inventors:
  • **Yabe, Hiroshi, c/o Seiko Epson Corporation**
  **Suwa-shi, Nagano-ken 392 (JP)**

  • **Ogihara, Tsutomu, c/o Seiko Epson Corporation**
  **Suwa-shi, Nagano-ken 392 (JP)**

(74) Representative: **Sturt, Clifford Mark et al**
**Miller Sturt Kenyon**
**9 John Street**
**London WC1N 2ES (GB)**

(56) References cited:
  **US-A- 4 114 363        US-A- 4 382 692**

  • **PATENT ABSTRACTS OF JAPAN vol. 4 no. 184**
  **(P-041) ,18 December 1980 & JP-A-55 128188**
  **(RICOH ELEMEX CORP) 3 October 1980,**

## Description

The present invention relates to a digital trimming circuit for correcting temporal shift of a time reference signal with regard to absolute time and in particular to a time reference signal in an IC (integrated circuit) used in a watch.

In any circuit which includes the use of a time reference signal, there will be the possibility of a temporal shift between the time reference signal and the absolute time. Accordingly, in those applications where accuracy is paramount, correcting methods are employed. One such application is in a conventional IC used in a watch. In this instance a time reference signal is outputted from an oscillator circuit. One correcting method, known as the digital trimming method, has been employed. In this method the time reference signal or the fundamental signal which is typically derived from a frequency-divided signal is expanded/compressed only by a required correction amount (digital trimming amount) during a predetermined correction period (digital trimming period).

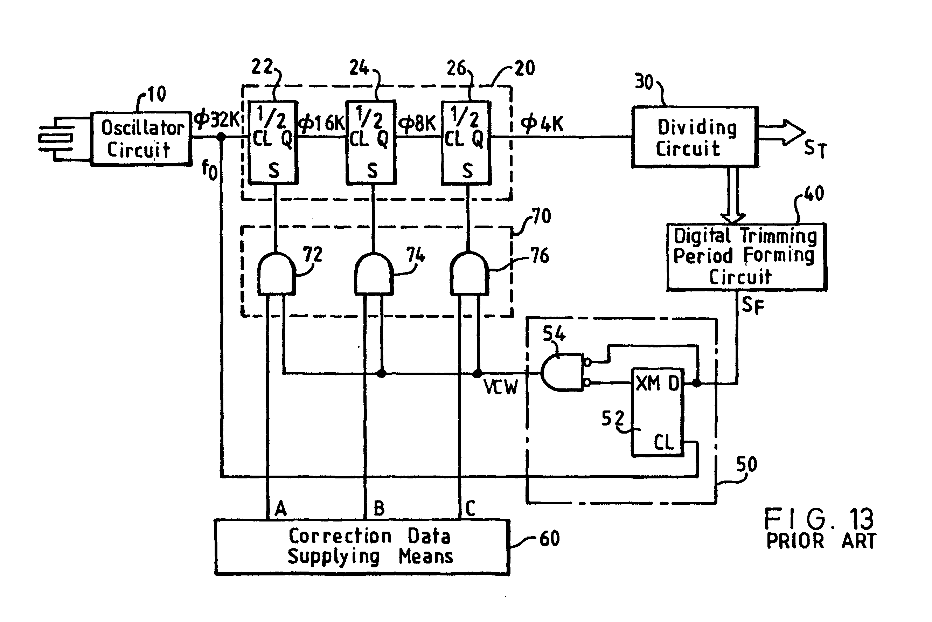

In Fig. 13, there is shown a digital trimming circuit for employing this conventional digital trimming method. This conventional digital trimming circuit includes an oscillator circuit 10 oscillating at a frequency $f_0$ of typically 32 KHz as a basic oscillation; a variable frequency dividing circuit 20 constructed of 1/2-frequency dividers 22, 24 and 26 with set data functions; a frequency dividing circuit 30 for obtaining a time reference signal $S_T$ from the variable frequency dividing circuit 20; and a digital trimming period forming circuit 40 for forming a digital trimming period signal $S_F$ based on the signal from the frequency dividing circuit 30. The digital trimming circuit further includes a digital trimming execution timing signal forming circuit 50 for forming a digital trimming timing signal VCW based upon the digital trimming period signal $S_F$ and the basic oscillation clock $f_0$; correction data supplying means 60 for supplying, for example, 3-bit correction data $(CBA)_2$; and a frequency division rate setting circuit 70 for sending the correction data $(CBA)_2$ into set inputs S of the 1/2-frequency dividers 22, 24, 26 upon generation of the digital trimming execution timing signal VCW. The digital trimming execution timing signal forming circuit 50 includes a latch 52 for receiving the digital trimming period signal $S_F$ as the data input D when the clock input CL is under a high level (which will be referred to hereinafter as a H level), for transferring this data input to the invert output XM, and for maintaining the invert output XM when the clock input CL is under a low level (which will be referred to hereinafter as a L level). The digital trimming execution timing signal further includes a NOR gate 54 for receiving as an input the digital trimming period signal $S_F$ and the invert output XM. The frequency dividing ratio setting circuit 70 is formed by a number of AND gates 72, 74 and 76.

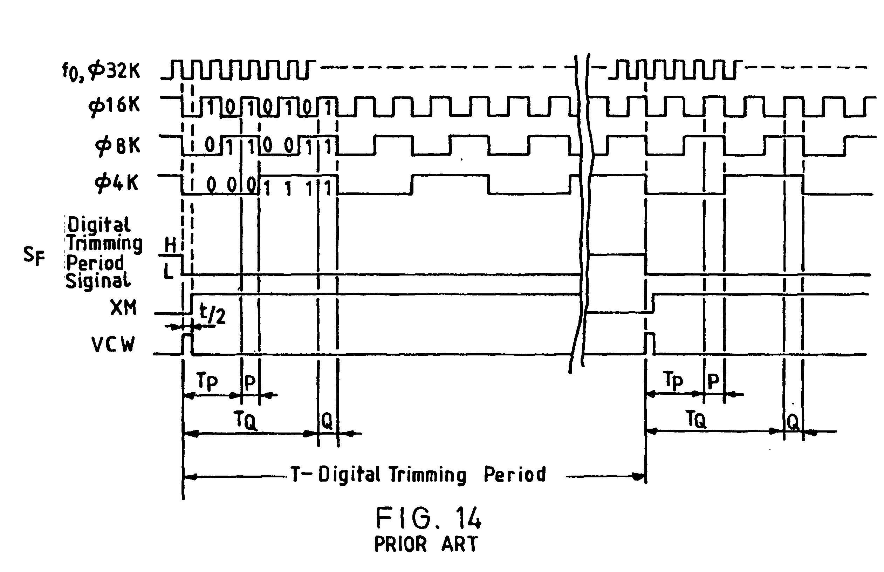

Normally, the time period T of the digital trimming period signal $S_F$ is a relatively long time period: typically anywhere between several seconds to several hundreds of seconds. As shown in Fig. 14, the digital trimming period signal $S_F$ is obtained by frequency dividing the output signal (4 KHz) of the 1/2-frequency divider 26 by the frequency dividing circuit 30. When the signal level of this digital trimming period signal $S_F$ is changed from the H level to the L level, all of 32 KHz-signal, 16 KHz-signal, 8 KHz-signal, and 4 KHz-signal are at the L level. The signal level of the digital trimming period signal $S_F$ is at the H level, and similarly the signal level of the basic oscillation frequency $f_0$, which is applied to the clock input CL, is at the H level just before this change of the falling edges from H to L levels. Consequently, the signal level of the invert output XM of the latch 52 is at the L level. Then, during a t/2 time period (1/2 time period ) where the basic oscillation frequency $f_0$ is at the L level, after the digital trimming period signal $S_F$ changes from the H level to the L level, the signal level of the invert output XM is maintained at the L level. As a consequence, the digital trimming execution timing signal VCW has the H level over this 1/2 time period.

If the signal state of the digital trimming timing signal VCW is at the H level, then the correction data can be applied to the variable frequency dividing circuit via the frequency division rate setting circuit. For example let the correction data $(CBA)_2$ be $(011)_2$. In this instance, the content of the variable frequency dividing circuit 20 is set to the condition of the point P during this t/2 time period. If, for example, the correction data $(CBA)_2$ is $(111)_2$, then the content of the variable frequency dividing circuit 20 is set to the condition of the point Q during this t/2 time period. As a consequence, when the variable frequency dividing circuit 20 is set to the point P, the period reference signal $S_T$ is shortened by a digital trimming amount $T_p$. Thus when the basic frequency $f_0$= 32 KHz, $T_p$ = (1/32 KHz) x 3 = 92 microseconds of digital trimming with respect to the digital trimming time period. Also, when the variable frequency dividing circuit 20 is set to the point Q, the period reference signal $S_T$ is shortened by a digital trimming amount $T_Q$. In this case $T_Q$ = (1/32 KHz) x 7 = 214 microseconds of digital trimming.

For the sake of an easy understanding of this prior art circuit, the correction data has 3-bits. However, actually this correction data is in the order of 5 bits. In this case, the maximum digital trimming amount reaches 0.98 milliseconds.

In general assume that a value of the correction data is selected to be K, a digital trimming amount $\Delta T$ is given by the following equation:

$$\Delta T = K \times t \qquad (1).$$

For instance, in the case of N-bit correction data, the correction data value K is 0 through $2^N-1$.

As a consequence, rate η corresponding to the digital trimming amount within a time period is given by

the following:

$$\eta = \Delta T/T = K \times t/T \qquad (2).$$

Also, the minimum rate $\mu$ corresponding to the minimum digital trimming rate is given by the following equation:

$$\mu = t/T \qquad (3).$$

The following problems have been identified with the above-described circuit. One problem is that there is a digital trimming amount $\Delta T$ for each digital trimming time period T. If the digital trimming amount $\Delta T$ becomes large, then the time reference signal is considerably expanded/compressed when the operation is being executed. As a consequence, if the time reference signal is used to clock a motor drive pulse output or an acoustic output, then the changes would be superimposed from the digital trimming which results in the waveforms of the respective output pulses being changed and so which may cause instability of the motor drive and the acoustic outputs to be interrupted. To avoid such a problem, one can withhold applying the digital trimming to the motor drive pulse outputs and the acoustic outputs. However, in many applications, such as a watch having a chronograph function in which a motor must be rotated at a fast time period for a long time, or a multi-hand/multi-motor watch in which a plurality of motors are controlled in an asynchronous mode are realised, or a watch having a melody output in which an acoustic output is continued for a long time, incorrect time reference frequency for a long period of time may cause problems. As a consequence, the digital trimming cannot be applied at all or their application means that the operations are interrupted. Therefore, in any case the time reference signal will drift from the basic time reference signal.

US-A-4,114,363 discloses an electronic timepiece having circuitry for automatically adjusting the time rate.

US-A-4,382,692 discloses an analogue-display electronic timepiece comprising a divider with an adjustable division factor.

CH-A-558559 and CH-A-534913 describe electronic watches in which a frequency divider is made adjustable by adding or suppressing pulses in the division chain.

The present invention has been made in an attempt to solve the above-described problems, and therefore, has an object to provide a digital trimming circuit capable of achieving an optimum rate. Also the digital trimming circuit suppresses the expansion/compression amount of the time reference signal when the operation is being carried out. Accordingly there should be no interference occurring between the digital trimming and the operations dependent on the time reference.

According to the present invention there is provided a digital trimming circuit for correcting temporal shift of a time reference signal derived from a basic oscillation signal comprising:

oscillator means for generating a basic oscillation signal, frequency division means for receiving said oscillation signal and dividing the frequency of the oscillation signal by a selected amount;
digital trimming means comprising means coupled to the frequency division means for selectively altering the state of the frequency division means at predetermined intervals in order to correct the time reference signal within a digital trimming time period;

characterised in that the digital trimming means comprises means for supplying correction data in the form of a digital word, a count means for receiving said digital word so as to be set to a value corresponding to the digital word, means coupled to receive a timing reference signal from said frequency division means and supplying a number of count pulses within the digital trimming time period to said count means, the number of count pulses being equal to said value to which said count means is set, timing adjustment means coupled to receive said count pulse and coupled to a stage of said frequency division means whereby in operation the provision of a count pulse decrements the count means and causes the timing adjustment means to provide a digital trimming execution control signal to a stage of said frequency division means for altering its logic state, and when a value of said count means is zero the correcting of the temporal shift of said time reference signal is finished.

Embodiments of the present invention, will now be described with reference to the accompanying drawings, in which:

Fig.1 is a schematic block diagram showing a circuit according to a first preferred embodiment of the present invention;
Fig. 2 is a timing chart for illustrating the operation of the first preferred embodiment;
Fig. 3 is a schematic block diagram representing a digital trimming circuit according to a second preferred embodiment of the present invention;
Fig. 4 is a flow chart illustrating the operation of a microcomputer employed in the first preferred embodiment;
Fig. 5 is a schematic block diagram illustrating a digital circuit according to a third example, which does not form part of the present invention;
Fig. 6 is a timing chart illustrating the operation of a binary rate multiplier in the third example;
Fig. 7 is a timing chart illustrating the operation of a synchronous differentiating circuit 244 employed in the third example;

Fig. 8 is a timing chart illustrating a lead digital trimming operation in the third example;

Fig. 9 is a timing chart illustrating a delay digital trimming operation in the third example;

Fig. 10 is a schematic block diagram illustrating a digital trimming circuit according to a fourth example, which does not form part of the present invention;

Fig. 11 is a timing chart illustrating the production of the digital trimming timing signal ZDnm in the fourth example;

Fig. 12 is a timing chart illustrating the operation of the clock selecting circuit in the fourth example;

Fig. 13 is a schematic block diagram illustrating a conventional digital trimming circuit; and

Fig. 14 is a timing chart illustrating the operation of the conventional digital trimming circuit.

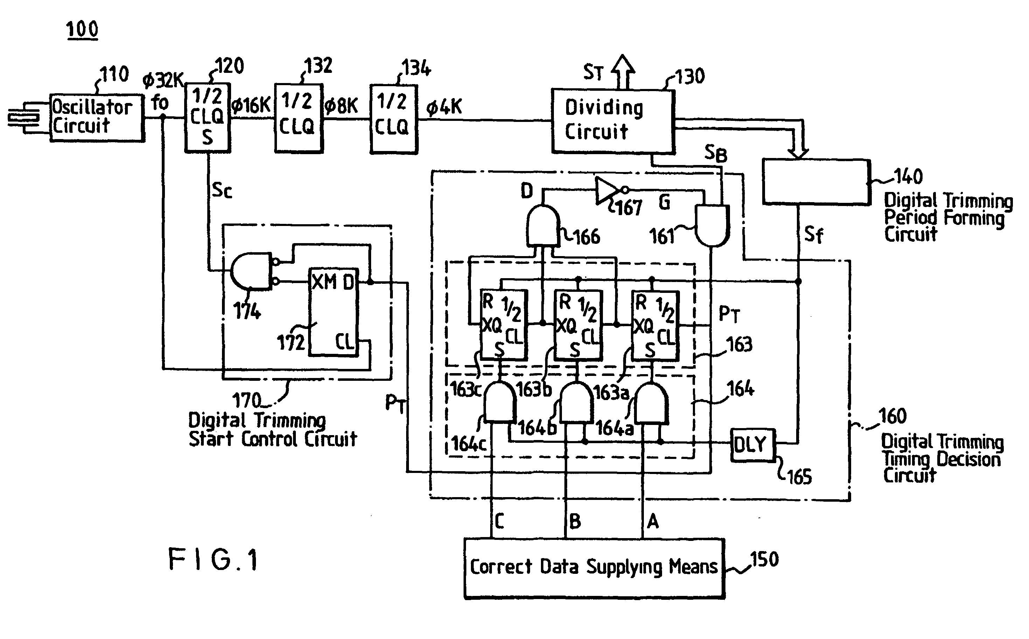

Fig. 1 is a schematic block diagram illustrating a digital trimming circuit according to a first preferred embodiment of the present invention. This digital trimming circuit 100 includes an oscillator circuit 110 oscillating at a basic oscillation frequency $f_0$ of typically 32 KHz; a 1/2-frequency divider 120 with a data setting function for applying a digital trimming amount; two further 1/2-frequency dividers 132 and 134 and when $f_0 = 32K$ for obtaining signals having frequencies of 8 KHz and 4 KHz; and a frequency dividing circuit 130 for frequency-diving the 4 KHz signal to obtain a time reference signal $S_T$. The digital trimming circuit 100 further includes:

a digital trimming period forming circuit 140 for forming a digital trimming period signal $S_F$ based on the signal of the frequency dividing circuit 130;

a digital trimming timing decision circuit 160 for producing a digital trimming timing signal (pulse) $P_T$, the quantity of which corresponds to correction data within a digital trimming time period and which is based upon the digital trimming period signal $S_F$, and for receiving a timing reference signal $S_B$ having a shorter period than the period of the digital trimming period signal $S_F$ and correction data $(CBA)_2$ from the correction data supplying means 150; and

a digital trimming start control circuit 170 for supplying the 1/2-frequency divider 120 with the data set function to start the correction by feeding a digital trimming execution control signal $S_c$ in response to the digital trimming timing signal $P_T$ and the basic clock $f_0$.

The digital trimming timing decision circuit 160 comprises an AND gate 161 acting as an open/close circuit, for receiving the timing reference signal $S_B$ in response to a gate open/close controlling signal, and for outputting the digital trimming timing signal $P_T$ over the signal passing time period; and a 3-bit down counter 163 constructed of 1/2-frequency dividers 163a, 163b, 163c with set/reset functions, which are reset by the digital trimming time period signal $S_F$, and also performs the count down operation of the correction data $(CBA)_2$ in response to the digital trimming timing signal $P_T$. The digital trimming timing decision circuit 160 further includes a correction data setting circuit 164 constructed of AND gates 164a, 164b and 164c for transferring the correction data (CBA) of the correction data supplying means 150 to the set terminal of the down counter 163. The correction data is transferred when the level of a delay signal which is produced from the digital trimming time period signal $S_F$ via a delay circuit 165 is change from H to L. The digital trimming timing decision circuit 160 further includes an AND gate 166 functioning as a digital trimming cancel detecting circuit for causing the detection output D to be H when all of the inverted outputs XQ from the respective 1/2-frequency dividers of the down counter 163 are H and an inverter 167 for inverting the detection output D to obtain the gate opening/closing control signal for the AND gate 161.

The digital trimming start control circuit 170 comprises a latch 172 for transferring the digital trimming timing signal $P_T$ to the invert output XM when the data input D and the level of the clock input CL becomes H, and for maintaining the invert output XM even when the level of the clock input CL becomes L. The digital trimming start control circuit also comprises a NOR gate 174 for inputting therein both of the digital trimming timing signal $P_T$ and the invert output XM and for outputting the digital trimming execution control signal Sc.

The purpose of the delay circuit 165 is provided, so as to give a time difference to allow the correction data $(CBA)_2$ to be set after the down counter 163 has been reset. It should be understood that the correction data supplying means 150 may be constituted by a means for converting the correction data into data in a form of binary notation $(CBA)_2$, given from an external operation member. The correction data thus comprises a signal input unit, a switch group for forming binary-notation $(CBA)_2$ form logic, and a network of connection/disconnection wires.

In general the time period T of the digital trimming period signal $S_F$ is a relatively long time period typically ranging from several seconds to several hundreds of seconds. Both of the digital trimming periods signal $S_F$ and the timing reference signal $S_B$ are obtained by frequency-dividing the output from the 1/2-frequency divider 134 by the frequency dividing circuit 130.

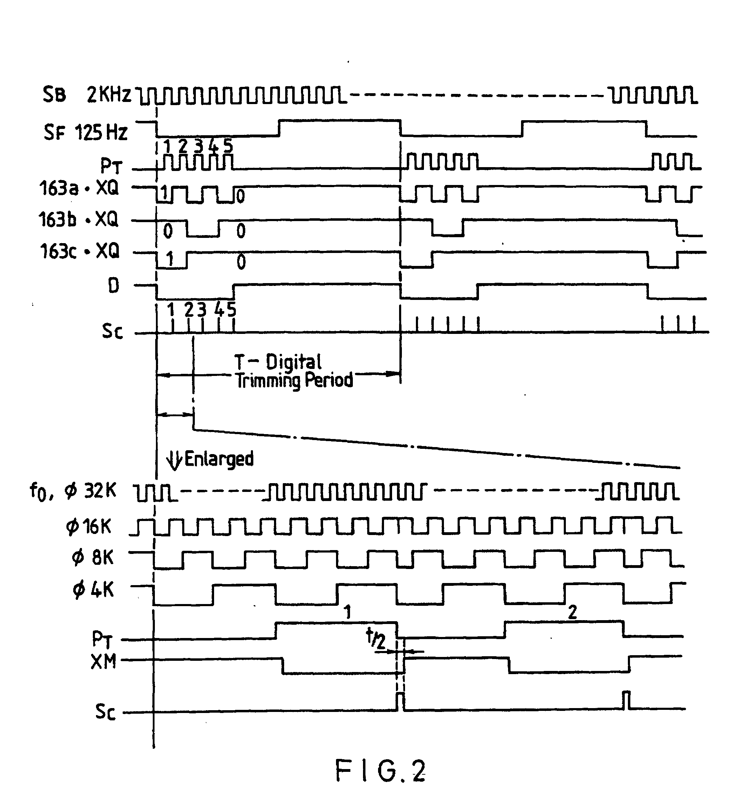

To facilitate understanding of the operation in this first preferred embodiment reference is made to Fig. 2. The digital trimming period signal $S_F$ is set to 125 Hz, and the timing reference signal $S_B$ is set to 2 KHz. The correction data $(CBA)_2$ is selected to be $(101)_2$. When the signal level of the digital trimming period signal $S_F$ changes from H to L, all the signal levels of the basic frequency $f_0$, the outputs of the frequency dividers 120, 132, 134, and the timing reference signal $S_B$ are at the L state. Now, if the signal level of the digital trimming period signal $S_F$ changes from H to L, since the 3-bit correction data $(101)_2$ is set to the down counter 163, the invert output XQ of the 1/2-frequency divider 163a is at L level, the input output XQ of the 1/2-frequency divider 163b is at H level, and also the invert output XQ of the 1/2-frequency divider 163c is at L level. With these signal conditions, the signal level of the detection output D from the AND gate 166 changes from H to L and the gate opening/closing control signal G changes from a L into H state, so that the AND gate 161, which functions as the opening/closing circuit, is opened. As a consequence, the timing reference signal $S_B$ passes through the AND gate 161 to become the digital trimming timing signal $P_T$. This timing signal $P_T$ is supplied to the down counter 163 as a clock input and to the digital trimming start control circuit 170 as an input signal. Every time the pulses of the digital trimming timing signal $P_T$ are entered into the down counter 163, the count down operation is performed, so that the count values are changed from $(101)_2$ through $(100)_2$ $(011)_2$, $(010)_2$, $(001)_2$ to $(000)_2$. When the fifth timing pulse is supplied to the down counter 163, the count value becomes $(000)_2$. Thus the invert output XQ of the 1/2-frequency divider 163a at this instant becomes H level, the invert output XQ of the 1/2-frequency divider 163b maintains H level, and the invert output XQ of the 1/2-frequency divider 163c becomes a H level. The signal level of the detection output D of the AND gate 166 changes from a L level to a H level, so that the signal level of the gate opening/closing control signal G changes from a H level to a L level. As a consequence, the AND gate 161 is closed, stopping the timing reference signal $S_B$ from passing through this AND gate. As described above, 5 pulses of the digital trimming signal $P_T$ are outputted between the AND gate 161 opening and closing.

When the signal level of the d/t timing signal $P_T$ changes from a H level to a L level, the basic clock frequency $f_0$ is at a L state. Prior to this falling edge the digital trimming timing signal $P_T$ is at the H level and similarly the basic oscillation clock $f_0$ functioning as the clock input CL is at the H state and accordingly the signal level of the invert output XM of the latch 172 is at the L state. Then, during the time period t/2 (1/2 time period) when the signal level of the digital trimming timing signal $P_T$ changes from the H level to the L level, and the signal level of the basic oscillation clock $f_0$ is at the L level, the L level of the invert output XM is maintained. Thus the digital trimming execution control signal $S_C$ has a H level over the t/2-time period. That is to say only during a half period of this basic oscillation period.

When the digital trimming execution control signal $S_C$ with the H level is supplied to the set input of the 1/2-frequency divider 120 the data set function is set to 1 and the signal level of the output Q, rather than changing from the H level to the L level, is maintained at the H level and so shortened only by 1 time period of the basic oscillation clock $f_0$. Similarly, the basic oscillation clock $f_0$ is shortened by 1 time period in response to the second, third, fourth and fifth digital trimming execution control signal $S_c$. When the basic frequency = 32 KHz, the time period is shortened by 30 microseconds with each pulse of the digital trimming execution control signal $S_c$. Overall, the basic oscillation clock $f_0$ is shortened by 5 x 30 = 150 microseconds in response to the five digital trimming initiations. As a result, the time reference $S_r$ obtained by frequency-dividing this basic oscillation clock $f_0$ is shortened by 150 microseconds within 1 digital trimming time period T.

It should be noted that this total digital trimming amount within 1 digital trimming time period is 150 microseconds and is not applied within 1 digital trimming initiation, but a plurality of digital trimming initiations are discretely or distributively allocated with 1 time period. Moreover, the digital trimming initiations need not be applied at equal intervals throughout one time period, merely distributed throughout. In this preferred embodiment, five sets of the digital trimming initiations in total are carried out for each time interval of the timing reference signal $S_B$ within 1 digital trimming time period in accordance with the correction data $(101)_2$. As a consequence, the digital trimming amount for 1 digital trimming initiation may be selected to be 1/5 of the total digital trimming amount, i.e., 30 microseconds. Thus, it is possible to neglect such adverse influences caused by digital trimming correction on systems such as a clock.

In a conventional system, the motor driving pulse typically has a pulse width of 3.9 milliseconds being continuously outputted at a rate of 128 pulses per second. If a 5-bit conventional digital trimming operation is performed, the pulse width of the motor driving pulse, or the pulse interval thereof, is varied by 0.98 milliseconds at most. This variation corresponds to 25% of the pulse width, or the pulse interval, and is not acceptable considering the stability of the motor drive. However, if the timing reference signal $S_B$ is selected to be 128 Hz, and a single digital trimming amount is set to 30 microseconds, the resultant adverse influence is reduced to 0.78%. Thus the shortening/expanding amount of the pulse width, or the pulse interval is negligible. As a consequence the digital trimming of the timings in the system can be effected, and therefore the setting operation can be improved.

Although the digital trimming timing decision circuit 160 is constructed of 1/2-frequency dividers and the like, this decision circuit may be formed from shift registers. Also, as will be discussed later, the digital trimming timing decision circuit 160 may be formed from a microcomputer (CPU) together with the digital trimming period forming circuit 140. Further, the digital trimming start control circuit 170 in the above-described first preferred embodiment is formed from the latch 172 and the NOR gate 174. However, this control circuit 170 is not limited thereto, but may be constructed of a delay means for slightly delaying the phase of the digital trimming tim-

ing signal $P_t$ with respect to the phase of the basic oscillation clock $f_0$ and an exclusive OR gate for producing the digital trimming execution control signal $S_c$ from the delayed digital triming timing signal and the basic oscillation clock $f_0$. Furthermore, in this preferred embodiment, the digital trimming operation with the minimum digital trimming amount (when the time period t of basic oscillation clock = 30 microseconds) is performed by way of a single stage 1/2-frequency divider 120. Alternatively, a number of 1/2-frequency dividers may be used but with no adverse influence on the system and the digital trimming amount may be increased. In addition, the digital trimming operation of this preferred embodiment has been described in terms of a time reduction in order to correct time delays. Alternatively, if the variation of the digital trimming timing signal $P_T$ is synchronised with the rising edge (L level to H level) of the frequency divider so that a time lead may be corrected. In this case, it is necessary to also simultaneously reset the frequency divider 132 in response to the digital trimming execution control signal $S_c$ in order that the adverse influences of the variation (H level to L level) are not given to the succeeding frequency divider. Also although 32 KHz is used as the oscillation frequency of the basic oscillation clock in this preferred embodiment, the present invention is not limited to this oscillation frequency. Any other oscillating circuits capable of oscillating at frequencies higher than, or lower than this 32 KHz may be employed so as to provide the basic oscillation clock.

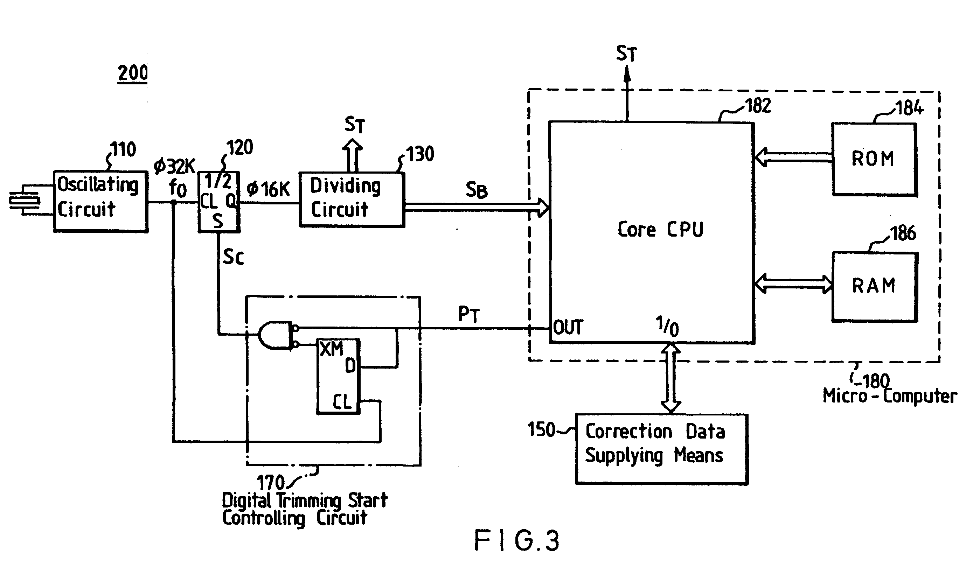

A second preferred embodiment will now be described. In this case the above-described digital trimming timing decision circuit 160 and digital trimming period forming circuit 140 are constructed by a microcomputer with remaining components similar to those of the first preferred embodiment. Fig. 3 is a schematic block diagram illustrating a logic digital trimming circuit 200 employing a microcomputer. It should be noted that the same reference numerals as shown in Fig. 1 will be employed for the same circuit portions in the following drawings, and the explanations thereof are omitted.

In this example, a microcomputer 180 is constructed of a core CPU 182, a ROM (read-only memory) 184 proving a program memory or the like, and a RAM (random access memory) 186 providing a counter or the like. This microcomputer 180 provides the respective functions of the digital trimming timing decision circuit 160 and the digital trimming period forming circuit 140 in the first preferred embodiment. A timing reference signal $S_B$ is inputted from a frequency dividing circuit 130 to the core CPU 182. The digital trimming period signal $S_F$ having a time period N-times higher than that of this timing reference signal $S_B$ (N being an integer), and other signals are produced within the microcomputer 180. The correction data in the form of serial data, or parallel data derived from the correction data supplying means 150 is inputted into the microcomputer 180. The digital trimming timing signal $P_T$ is outputted to the digital trimming start control circuit 170 from the microcomputer 180.

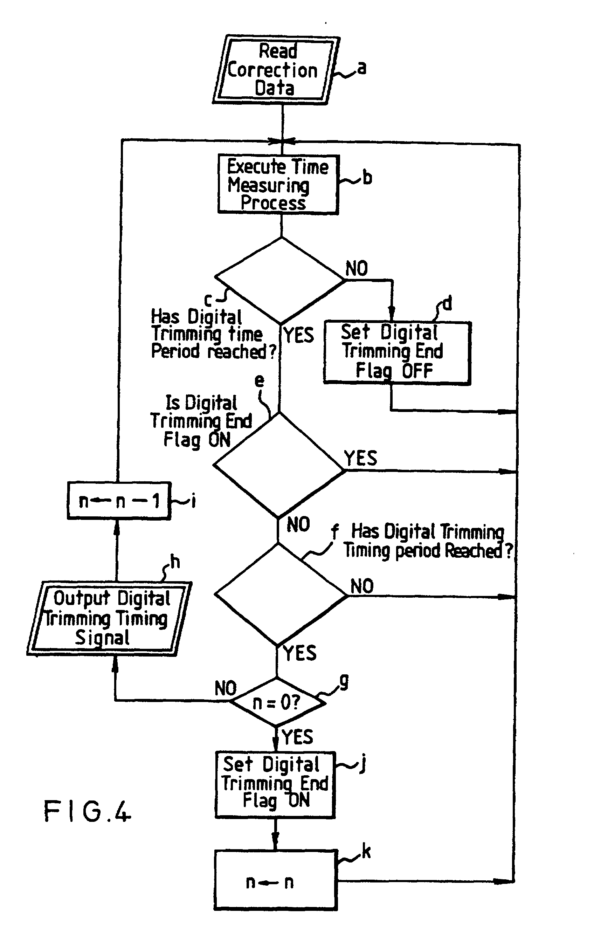

Fig. 4 is a flow chart for representing the operation of the microcomputer according to this second preferred embodiment. At a first step a of this flow chart, the core CPU 180 reads the correction data, and stores a digital trimming initiation number n to be executed within 1 digital trimming time period in a digital trimming initiation number counter. At the next step b, a time measuring process is carried out. This time measuring process derives the time reference signal $S_T$ by counting during the digital trimming time period, and also during the timing reference signal $S_B$. At the next step c, a judgement is made whether or not the digital trimming time period has elapsed. If the digital trimming time period has not yet elapsed then a digital trimming end flag is set OFF at the subsequent step d, and the process returns to the previous step b to continue counting. If however a judgement is made that the digital trimming time period has elapsed, then a check is made to see whether the digital trimming end flag is turned ON at a step e. If the digital trimming end flag is ON, then the process returns to the previous step b. Conversely, if the digital trimming end flag is OFF, then a judgement is made as to whether or not the digital trimming timing period has elapsed at a further step f. At this step f, when it is judged that the digital trimming timing period has not yet elapsed, the process returns to step b. However, when it is judged that the digital trimming timing period has elapsed, then another judgement is made at a step g as to whether or not the digital trimming initiation number n is equal to zero. If it is established, at this step g, that this initiation number n is not equal to zero, one digital trimming timing signal $P_T$ is outputted to the digital trimming start control circuit 170 at a step h. Correction of the time reference is thus carried out. After this process defined at step h has been executed, the initiation number is reduced by 1 at a step i and then the process returns to step b. n timing signals $P_T$ are sent out until the initiation counter reaches zero. Accordingly, it is judged that n = 0 at step g, and the digital trimming end flag is then set to ON at step j. After the process defined at step j has been executed, the content of the digital trimming initiation number counter is set to n at step k in order to return to the initial number. Thereafter, the process returns to step b.

As described above, a microcomputer may form the digital trimming timing decision circuit 160 and the digital trimming period forming circuit 140 to provide the timing controls.

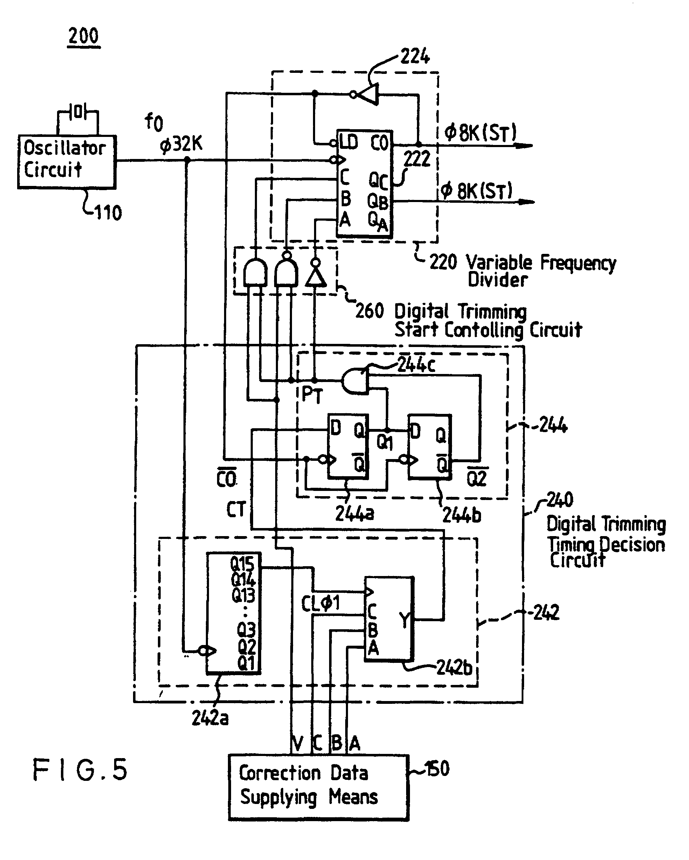

Fig. 5 is a schematic block diagram illustrating a digital trimming circuit according to a third example, which does not form part of the present invention. A digital trimming circuit 200 according to this example includes an oscillator circuit 110 oscillating at a frequency of preferably 32 kHz as a basic oscillation frequency $f_0$; a variable frequency divider 220 functioning as a digital trimming amount applying means, for producing a time reference signal $S_T$ based upon this basic oscillation frequency $f_0$; and a digital trimming timing decision circuit 240 for producing a digital trimming timing (pulse) signal $P_T$. The number of pulses of $P_T$ corresponds to digital trimming data $(CBA)_2$ within 1 digital trimming time period based upon both of the basic oscillation frequency $f_0$ and the digital trimming data $CD = (CBA)_2$ from the correction data derived from the correction data supplying means 150. Furthermore, this digital trimming circuit 200 employs a digital trimming start control circuit 260 for designating a frequency division ratio of the frequency divider 220 based upon delay-speed designation data $(V)_2$ and the digital trimming timing signal $P_T$ from the correction data.

The variable frequency divider 220 corresponds to a down counter with a data set function and includes a clock input for the basic oscillation frequencies $f_0$; 3-bit data set inputs A, B, C; 3 bit count outputs $Q_A$, $Q_B$, $Q_C$; a zero signal output CO for outputting a signal with a H level when the count value is zero; and a load input LD into which an invert signal $\overline{CO}$ of zero signal CO is inputted via an inverter 222. From this zero signal CO of the variable frequency divider 220, a time reference signal $S_T$ is derived. Normally, the variable frequency divider 220 operates as a 1/4-frequency divider, but may also operate in any one of 1/3 frequency division and 1/5 frequency division being inserted instead of the 1/4-frequency dividing operation. The division being set in response to the value of the delay-speed designation data, as will be discussed later.

The timing decision circuit 240 comprises a pulse generation circuit 242 for generating digital trimming timing pulses CT at substantially equi-intervals within each time period T and a synchronous differentiate circuit 244 for producing one digital trimming timing signal PT in detection of the rising edge of the digital trimming timing pulse CT. The pulse generation circuit 242 comprises a frequency divider 242a for frequency-dividing the basic oscillation clock $f_0$ by $1/2^{15}$ to produce a 1 Hz-pulse reference clock $CL\phi1$, and also a binary rate multiplier (BRM) 242b for deriving the output pulse CT: the number of which is set by the digital trimming data $(CBA)2$, within each digital trimming time period T (namely, a period of 8 reference clocks $CL\phi1$ in this example). The synchronous differentiating circuit 244 comprises a first-staged D flip-flop 244a having an invert signal $\overline{CO}$ of the zero signal as a clock input, and the digital trimming timing pulse CT as a data input D; a second-staged D flip-flop 244b has the Q output of the first D flip-flop 244a as a data input D, and the invert signal $\overline{CO}$ as a clock input; and furthermore an AND gate 244c having the $\overline{Q}$ output of the second staged D flip-flop 244b as a $\overline{Q2}$ input to produce the digital trimming timing signal $P_T$.

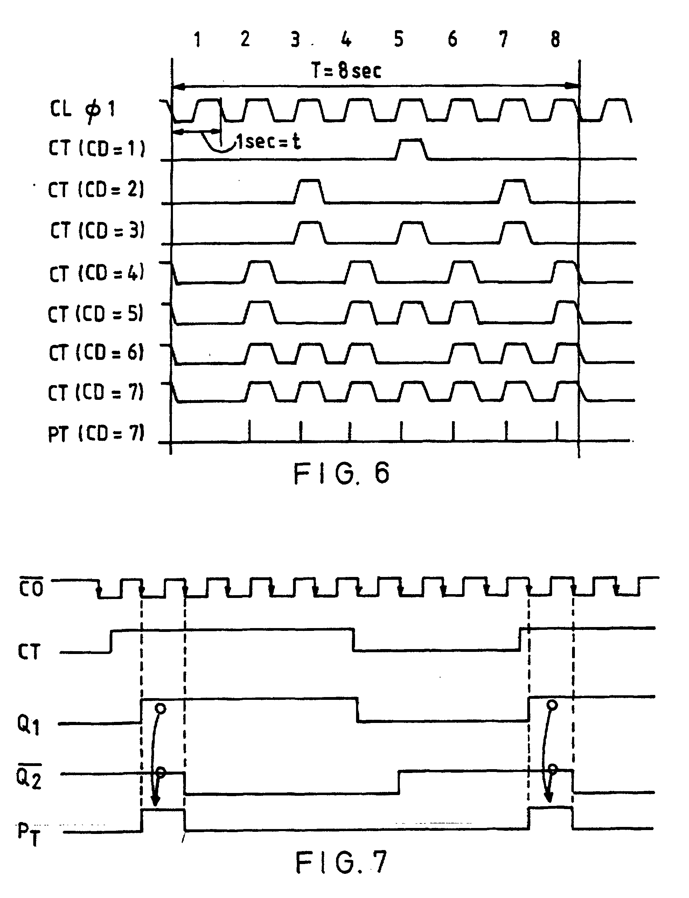

Referring now to the timing charts shown in Figs. 6 to 9, the operations of the above-described example will be explained. The frequency divider 242a frequency divides the basic oscillation clock $f_0$ by $1/2^{15}$ to

produce a pulse reference clock $CL\phi1$, as shown in Fig. 6, and supplies this reference clock to the binary rate multiplier (BRM) 242b. It should be noted that a time period during which 8 reference clocks $CL\phi1$ are generated, corresponds to 1 digital trimming time period T = 8t. The rate multiplier (BRM) 242b outputs the digital trimming timing pulse CT, the pulse number of which corresponds to the number of the digital trimming data $CD = (CBA)_2$ with respect to the 8 reference clocks.

When the digital trimming data CD = 1, namely $(CBA)_2 = (001)_2$,
only the 5th reference clock $CL\phi1$ is derived.

When the digital trimming data CD=2, namely $(CBA)_2 = (010)_2$,
only the 3rd and 7th reference clocks $CL\phi1$ are derived.

When the digital trimming data CD is equal to 3, namely $(CBA)_2 = (011)_2$,
the 3rd, 5th and 7th reference clocks $CL\phi1$ are derived.

When the digital trimming data CD is equal to 4, namely $(CBA)_2 = (100)_2$,
the 2nd, 4th, 6th and 8th reference clocks $CL\phi1$ are derived.

When the digital trimming data CD = 5, namely $(CBA)_2 = (101)_2$,
the 2nd, 4th, 5th, 6th and 8th reference clocks $CL\phi1$ are derived.

When the digital trimming data CD = 6, namely $(CBA)_2 = (110)_2$, the 2nd, 3rd,
4th, 6th, 7th and 8th reference clocks $CL\phi1$ are derived.

When the digital trimming data CD = 7, namely $(CBA)_2 = (111)_2$, the 2nd, 3rd,
4th, 5th, 6th, 7th and 8th reference clocks $CL\phi1$ are derived.

The rate multiplier 242b produces a predetermined number of pulses within each digital trimming time period T, and divides each digital trimming time period T, so that the pulses are outputted at substantially equiintervals. The invert signal $\overline{CO}$ of the zero signal CO from the variable frequency divider 220 is applied to the clock inputs of the D flip-flops 244a and 244b of the synchronous differentiate circuit 242. As will be discussed, normally, this invert signal $\overline{CO}$ corresponds to a 1/4-frequency division signal. When the output pulse CT of the rate multiplier 242b is produced, the D flip-flop 244a stores the output pulse CT and generates a waveform Q1 as shown in Fig. 7. Also, the D flip-flop 244b stores the waveform Q1 and generates a waveform $\overline{Q2}$ from the $\overline{Q}$ output, as shown in Fig. 7. It should be noted that since the falling edge of the waveform $\overline{Q2}$ contains 1 clock delay with respect to the rising edge of the waveform Q1, the pulse width of the digital trimming timing signal $P_T$ outputted from the AND gate 244c corresponds to 1 clock period of the invert signal $\overline{CO}$.

As described above, the pulse width of the pulse CT generated from the rate multiplier (BRM) 242b is compressed by the synchronous differentiate circuit 244, thereby generating the digital trimming timing signal $P_T$.

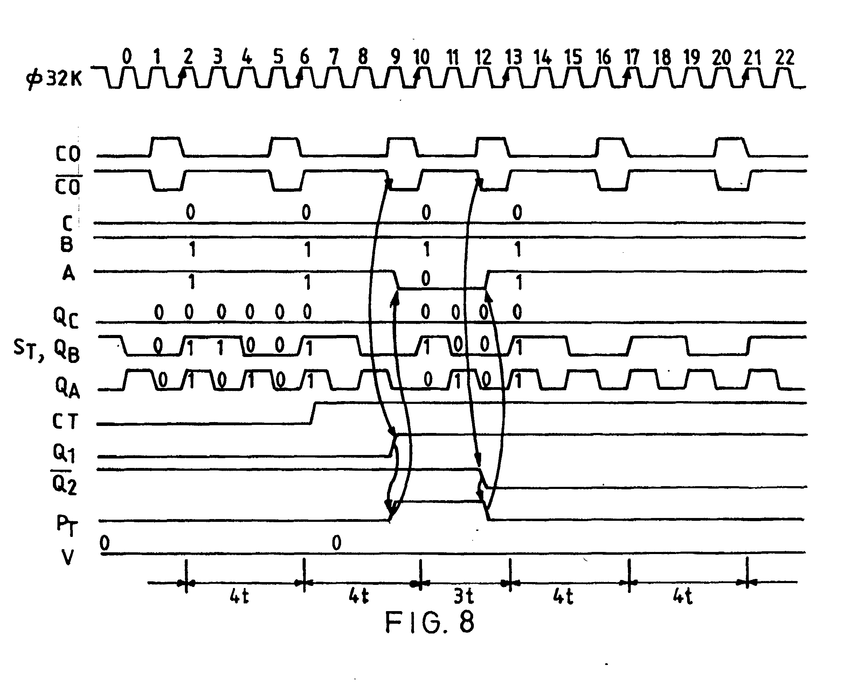

As represented in Fig. 8, when the delay speed data $(V)_2$ derived from the correction data supplying means 150 is equal to $(0)_2$, the level of the digital trimming timing signal $P_T$ is L, and the logic value of $(CBA)_2 = (011)_2$. The digital trimming start control circuit 260 is set to the down counter 222 as an initial value at the rising edge of the invert signal $\overline{CO}$. As a consequence, every time the basic oscillation clock $f_0$ is inputted, the count value $(Q_C, Q_B, Q_A)$ is shifted from $(011)_2$, but is again set to the initial value $(011)_2$ each time the zero signal CO is produced. Accordingly the variable frequency divider 220 performs 1/4-frequency division when the delay speed data $(V)_2$ is equal to $(0)_2$ and the level of the digital trimming timing signal $P_T$ is L.

When the delay speed data $(V)_2$ is $(0)_2$ and the level of the digital trimming timing signal $P_T$ goes to H level, as indicated in Fig. 8, the logic value $(CBA)_2$ of the digital trimming start control circuit 260 becomes equal to $(010)_2$. This logic value $(010)_2$ is set to the down counter 222 as an initial value at the rising edge of the invert signal $\overline{CO}$. As a result, every time the basic oscillation clock $f_O$ is inputted the count value $(Q_C, Q_B, Q_A)_2$ is shifted from the $(010)_2$ via $(001)_2$ to $(000)_2$, and is again set to the initial value of $(010)_2$ at the subsequent clock on the occurrence of the zero signal CO. Thus, when the delay speed $(V)_2$ is $(0)_2$ and the level of the digital trimming timing signal $P_T$ go to H, the variable frequency divider 220 executes a 1/3-frequency dividing operation only once.

As described above, the time reference signal $S_T$ is shortened only by 1 time period of the basic oscillation clock in accordance with a single 1/3-frequency dividing operation in response to a single digital trimming timing signal $P_T$. As a result, when n digital trimming timing (pulse) signals $P_T$ are produced within each digital trimming time period T, the quickening digital trimming operation is carried out only n times within each digital trimming time period T. In this way this example can achieve advantages similar to that of the first and second preferred embodiments. Moreover, according to this example, since the rate multiplier 242b is employed so as to produce the digital trimming timing signal $P_T$ at equi-intervals within each digital trimming time period, there is another merit in that a plurality of the digital trimming operations can be equally dispersed within each digital trimming time period. This is in contrast to the prior art where a plurality of digital trimming operations are concentrated at the beginning of the digital trimming time period. Accordingly any adverse influence may be even further mitigated.

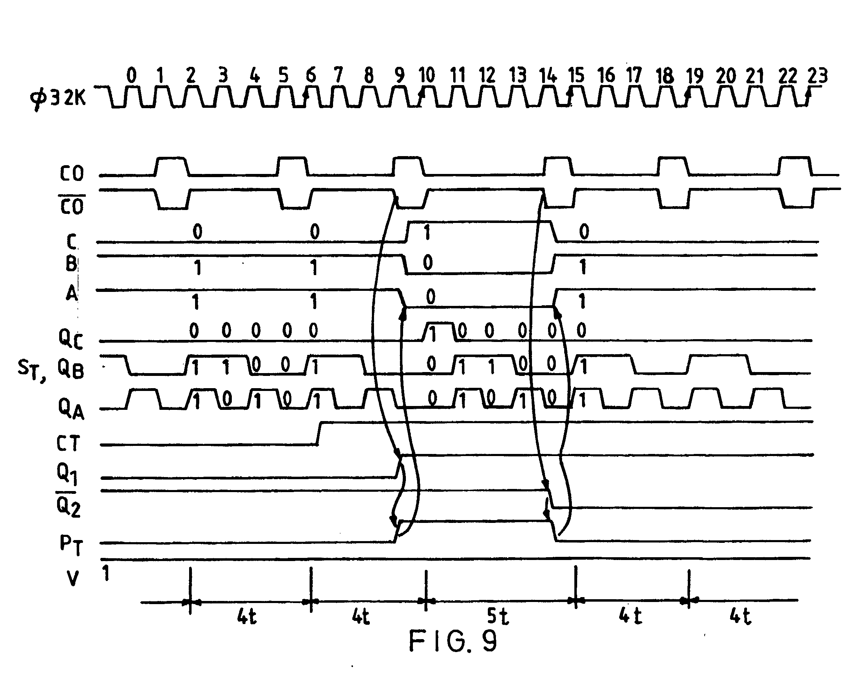

Next, when the delay-speed data $(V)_2$ supplied from the correction data supplying means 150 is $(1)_2$, and the level of the digital trimming timing signal $P_T$ is L, as shown in Fig. 9, the logic value $(CBA)_2 = (011)_2$ of the digital trimming start control circuit 260 is set as an initial value to the down counter 222 at the rising edge of the invert signal $\overline{CO}$. As a result, every time the basic oscillation clock $f_O$ is inputted, the count value $(Q_C\ Q_B\ QA)$ is shifted from $(011)_2$ via $(010)_2$ and $(001)_2$ to $(000)_2$, and is again set to the initial value $(011)_2$ in response to the subsequent occurrence of the zero signal CO. Accordingly, when the delay speed data $(V)_2$ is $(1)_2$ and the level of the digital trimming timing signal $P_T$ is L, the variable frequency divider 220 performs 1/4-frequency dividing operation. That is to say when the level of the digital trimming timing signal $P_T$ is L, the variable frequency divider 220 performs 1/4 frequency division irrelevant of the level of the delay speed data $(V)_2$.

When the delay speed data $(V)_2$ is equal to $(1)_2$ and the level of the digital trimming timing signal $P_T$ goes H, as represented in Fig. 9, the logic value $(CBA)_2 = (100)_2$ of the digital trimming start control circuit 260 is set to the down counter 222 as the initial value at the rising edge of the invert signal $\overline{CO}$. As a consequence, every time the basic oscillation clock $f_0$ is inputted, the count value $(Q_c\ Q_B\ Q_A)$ is shifted from $(100)_2$ via $(011)_2$, $(010)_2$, $(001)_2$ to $(000)_2$. Then, this count value is again set to the initial value $(100)_2$ in response to the subsequent zero signal CO. Accordingly, when the delay speed data $(V)_2$ becomes $(1)_2$, and the level of the digital trimming timing signal $P_T$ is H, the variable frequency divider 222 performs the 1/5-frequency dividing operation only once. Thus, the time reference signal $S_T$ is expanded only by 1 time period of the basic oscillation clock $f_0$ in accordance with a single 1/5-frequency dividing operation by a single digital trimming timing signal $P_T$. As a result, when n digital trimming timing signals $P_T$ are produced within each digital trimming time period, a delay operation is carried out by n time periods of the basic oscillation clock $f_0$ within each digital trimming time period T. In accordance with this example, since the digital trimming timing signals $P_T$ are generated at substantially equi-intervals a plurality of digital trimming operations can be equally dispersed within each digital trimming time period. This is in contrast to the prior art where a plurality of digital trimming operations are concentrated at the initial stage of the digital trimming time period.

It should be noted that since a duty ratio of the zero signal CO from the variable frequency divider 220 is not equal to 50%, there are some cases when this zero signal is not properly used as the clock of the time reference signal $S_T$. In such a case, the duty ratio of this zero signal CO is processed by a wave shaping circuit, or the like to be 50%, and this shaped zero signal may be used as the time reference signal $S_T$. In this third preferred embodiment, it is so arranged that the digital timing signal $P_T$ is produced: the number of pulses of which corresponds to the value of the digital trimming data CD. Alternatively, since detection can be done by way of monitoring the digital trimming timing signal $P_T$, a process operation such as an interruption for other circuit blocks may be performed.

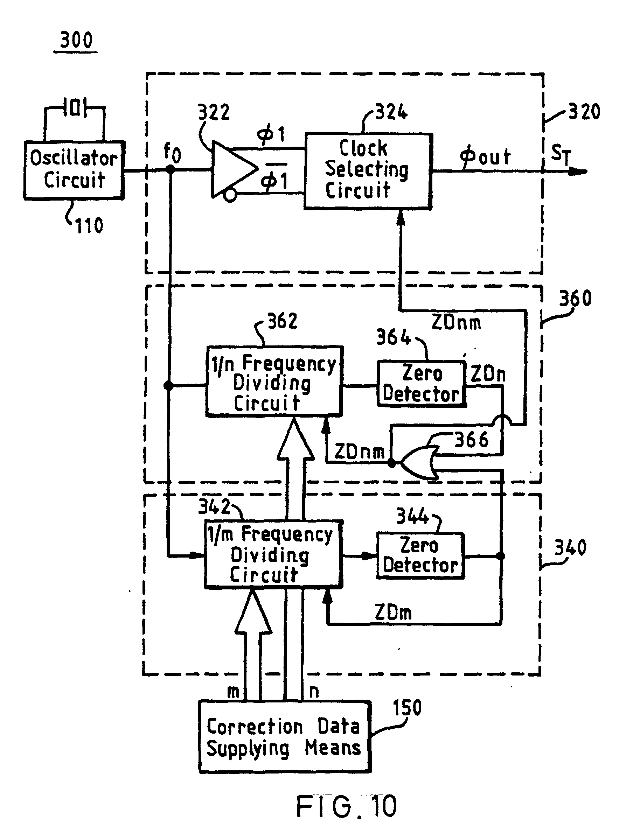

Fig. 10 is a schematic block diagram illustrating a digital trimming circuit according to a fourth example, which does not form part of the present invention. A digital trimming circuit 300 is constructed of an oscillator circuit 110 oscillating at a basic oscillation frequency of typically 32 kHz; a digital trimming applying circuit 320 for executing a digital trimming operation on this basic oscillation clock $f_0$ in response to a digital trimming timing signal ZDnm, thereby outputting a time reference signal $S_T$; a digital trimming period decision circuit 340 for outputting a period pulse ZDm from correction data m (digital trimming period designation data) which is supplied from a correction data supplying means 150; and also a digital trimming timing decision circuit 360 for producing digital trimming timing signal ZDnm based upon both of the digital trimming period pulse ZDm and the correction data n (digital trimming interval designation data) which is derived from the correction data supplying means 150.

The digital trimming applying circuit 320 comprises a complementary output circuit 322 for outputting an in-phase clock ø1 and a reverse phase clock $\overline{ø1}$ from the basic oscillation clock $f_0$; and a clock selecting circuit 324 for selecting the in-phase clock ø1 or the reverse phase clock $\overline{ø1}$ in response to the digital trimming timing signal ZDnm and for sending out the selected clock øout as the time reference signal $S_T$. The digital trimming period decision circuit 340 comprises a 1/m-frequency dividing circuit 342 functioning as a down counter with a preset function, into which an initial value m is set in response to the digital trimming period pulse ZDm; and also a zero detecting circuit 344 for detecting when the count value of this down counter becomes zero. The digital trimming timing decision circuit 360 comprises a 1/n-frequency dividing circuit 362 functioning as a down counter with a preset function, into which an initial value n is set in response to the digital trimming timing signal ZDnm; a zero detecting circuit 364 for detecting when the count value of this down counter becomes zero; and also an OR gate 366 for producing the digital trimming timing signal ZDnm based upon the zero detection signal ZDn of the zero detecting circuit 364 and the digital trimming period pulse ZDm as the zero detection signal.

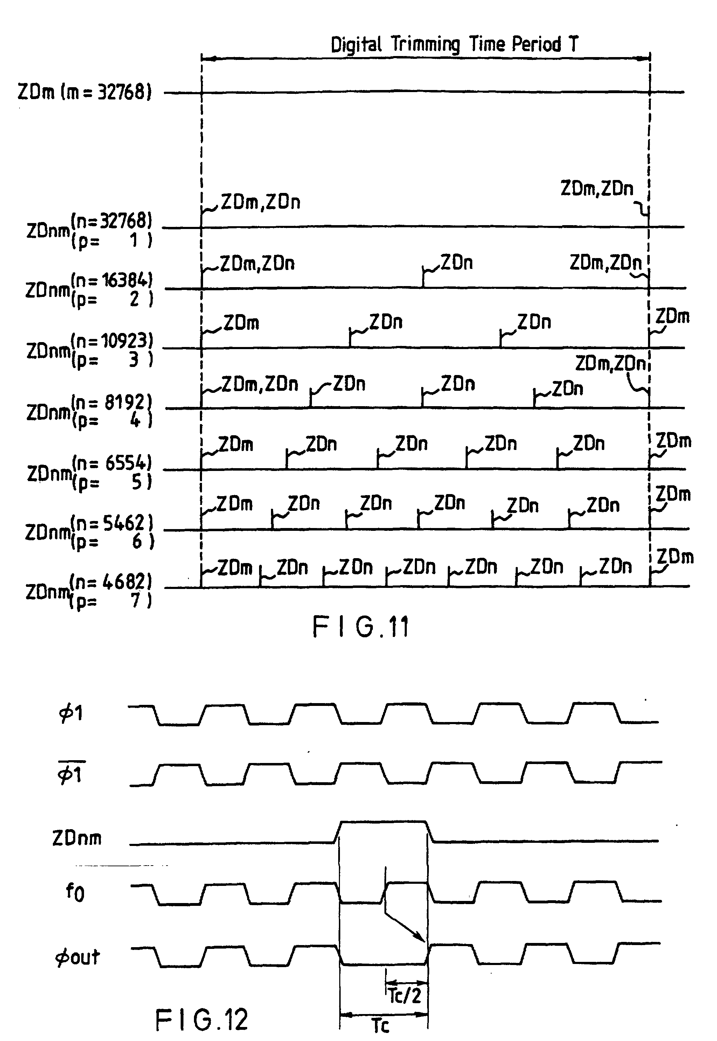

The initial value m is supplied from the correction data supplying means 150 to the 1/m-frequency dividing circuit 342 which executes the count down operation upon receipt of the basic oscillation clock $f_0$. When the count value becomes zero, the zero detection signal ZDm is generated from the zero detecting circuit 344, so that the initial value m is again set to this 1/m-frequency dividing circuit 342. As described above, as shown in Figure 11, the zero detection signal ZDm is produced every time m pieces of basic oscillation clocks $f_0$ are generated, which will then form a period pulse. On the other hand, the initial value n is also supplied from the correction data supplying means 150 to the 1/n-frequency dividing circuit 362 which will then execute the count down operation upon receipt of the basic os-

cillation clock $f_0$. When the count value of this down counter becomes zero, the zero detection signal ZDn is generated from the zero detecting circuit 364, so that the initial value n is not only set to this 1/n-frequency dividing circuit 362, in response to the zero detection signal ZDn, but also the initial value m is set thereon in response to the digital trimming period pulse ZDm of the zero detecting circuit 344. To produce the digital trimming timing signals ZDnm at substantially equi-intervals within each digital trimming time period T, the correction data m and n have the following relationship:

$$(n \times P) - m = r,$$

where r indicates a minimum positive integer small than n, and P denotes the number of digital trimming timing signals ZDnm generated within 1 digital trimming time period T.

Assuming now that the correction data m is equal to $2^{15} = 32768$, as indicated in Figure 11, the digital trimming period pulse is outputted from the zero detecting circuit 344 when the 32768th basic oscillation clock is produced. In this case, the digital trimming operation is executed at the starting point of the digital trimming time period T. When n = 16384, since the zero detection signal ZDn is also produced when the 16384th basic oscillation clock $f_0$ is generated, p = 2 and r=0. As a consequence, the digital trimming operations are executed at the starting point of the digital trimming time period T and at t/2. When n=10923, the zero detection signal ZDn is produced when the 10923rd and 21846th basic oscillation clocks $f_0$ are produced, the digital trimming period pulse ZDm is produced before the 32769th basic oscillation clock $f_0$ is generated. The interval between the 21846th basic oscillation clock and the start of the digital trimming time period, is shorter than the other pulse interval by only 1 basic oscillation clock. However, since this shorter interval corresponds to a difference of 1 % of the time interval, it can be asserted that the digital trimming timing signals ZDnm are allocated at substantially equi-intervals.

According to this fourth example, a plurality of digital trimming operations can be uniformly dispersed within 1 digital trimming time period, since a number of the digital trimming operations are not concentrated at the beginning of the digital trimming time period, as compared with the prior art. Furthermore, the digital trimming timing signal is not obtained by curtailing the input pulses as compared with the third example. The rounding effects of the digital trimming period pulse ZDn occur even when n=6554, 5462 and 4682 as shown in Figure 11. The rounding effects can become negligible by setting the value of m to a large value.

The operation of the digital trimming amount applying circuit 320 will now be described. As shown in Figure 12, in the clock selecting circuit 324, every time the digital trimming timing signal ZDnm is produced, the output signal øout is changed. For instance, when the in-phase clock ø1 has been selected as the output signal øout, if the digital trimming timing signal ZDnm is inputted into the clock selecting circuit 324, the clock selecting circuit 324 selects the reverse phase clock $\overline{ø1}$ as the output signal øout. Similarly when the reverse clock $\overline{ø1}$ is inputted, the clock selecting circuit 324 selects the in-phase clock ø1 as the output signal øout. The clock selecting circuit 324 switches between the in-phase and reverse phase clocks when the output signal øout is low. Accordingly, the output signal øout when the changeover occurs, is extended by a half period (Tc/2) of the basic oscillation clock $f_0$, as shown in Figure 12.

In the above-described first and second preferred embodiments and the third example, the variable frequency divider has been employed as the digital trimming supplying means and the method for changing the frequency dividing ratio based on the digital trimming timing has been employed. In contrast, this fourth example employs a method whereby the output signal is altered by a half of the clock time period in response to the changeover between the in-phase clock ø1 and the reverse clock $\overline{ø1}$. As a result, since the minimum digital trimming amount does not correspond to one time period of the basic oscillation clock, but a half period thereof, the effect of the digital trimming operation on the expansion/reduction ratio of the time reference signal may be further suppressed.

As previously described in detail, in accordance with the present invention, a dispersive method is employed in which a plurality of digital trimming operations each with a little digital trimming are dispersively executed within each digital trimming time period. To achieve this, there is provided the digital trimming supplying means for executing the digital trimming operation with a predetermined digital trimming in response to the initiation control signal. The digital trimming amount-to-pulse number converting means for producing the initiation control pulse signal is also provided. The number of which corresponds to the correction data for designating the digital trimming which should be executed. As a consequence, since the initiation control pulse signals are obtained within one time period, a plurality of operations is dispersively performed within one time period. The digital trimming of the digital trimming applying means is coincident with such a value calculated by dividing, for instance, the digital trimming to be operated within 1 time period by the pulse number, so that the digital trimming required within 1 digital trimming time period is applied. Thus the digital trimming can be coincident with the logic digital trimming rate required for the time reference signal. Also, the expansion/reduction amount for the time reference signal at the digital trimming timing can be suppressed. That is to say, since the operation with the minimum expansion/reduction amount corresponding to the time period of the basic oscillation signal can be realized, interference caused by the digital trimming timing may become negligible or greatly suppressed. In this case with the digital trimming amount-to-pulse number converting means, the digital trimming timing equal-allocating means is employed by which the initiation control signal is generated at substantially equiintervals which may be calculated by dividing 1 digital trimming time period by the above-described pulse number, a plurality of digital trimming timings are not concentrated into one portion of the digital trimming time period, but are dispersed throughout., As a result, any adverse influence applied to the output timing can be mitigated.

Furthermore, because the complementary signal forming means for forming the in-phase signal and the reverse phase signal and also the signal selecting means for selecting the in-phase signal and the reverse phase signal to be outputted are employed as the digital trimming applying means, then the digital trimming operation with the minimum digital trimming equal to a half time period of the original oscillation signal can be performed. Thus the above-described advantages can be achieved.

The aforegoing embodiments have been given by way of example only and it is to be appreciated by a person skilled in the art that modifications may be made without departing from the scope of the present invention.

## Claims

1. A digital trimming circuit for correcting temporal shift of a time reference signal ($S_T$) derived from a basic oscillation signal ($f_0$) comprising:

   oscillator means (110) for generating a basic oscillation signal ($f_0$), frequency division means (120, 132, 130) for receiving said oscillation signal and dividing the frequency of the oscillation signal by a selected amount;
   digital trimming means (140-170) comprising means coupled to the frequency division means for selectively altering the state of the frequency division means at predetermined intervals in order to correct the time reference signal ($S_T$) within a digital trimming time period (T);

   **characterised in that** the digital trimming means comprises means for supplying correction data (150) in the form of a digital word, a count means (163) for receiving said digital word so as to be set to a value corresponding to the digital word, means (161) coupled to receive a timing reference signal ($S_B$) from said frequency division means and supplying a number of count pulses ($P_T$) within the digital trimming time period (T) to said count means, the number of count pulses ($P_T$) being equal to said value to which said count means is set, timing adjustment means (170) coupled to receive said count pulse ($P_T$) and coupled to a stage of said frequency division means whereby in operation the provision of a count pulse decrements the count means and causes the timing adjustment means to provide a digital trimming execution control signal ($S_C$) to a stage (120) of said frequency division means for altering its logic state, and when the value of said count means is zero the correcting of the temporal shift of said time reference signal is finished.

**2.** A circuit as claimed in claim 1 in which said digital trimming means comprises a microcomputer.

**3.** A timepiece including a circuit as claimed in claim 1 or claim 2.

**Patentansprüche**

**1.** Digitalabgleichschaltung zum Korrigieren einer zeitlichen Verschiebung eines Zeitreferenzsignals ($S_T$), das aus einem Grundschwingungssignal ($f_0$) abgeleitet wird, umfassend:

ein Oszillatormittel (110) zum Erzeugen eines Grundschwingungssignals ($f_0$), ein Frequenzteilermittel (120, 132, 130) zum Empfangen des Schwingungssignals und Teilen der Frequenz des Schwingungssignals durch eine ausgewählte Größe;
ein Digitalabgleichmittel (140-170), das ein Mittel umfaßt, das mit dem Frequenzteilermittel gekoppelt ist, um den Zustand des Frequenzteilermittels in vorgegebenen Intervallen selektiv zu ändern, um das Zeitreferenzsignal ($S_T$) innerhalb einer Digitalabgleich-Zeitperiode (T) zu korrigieren;

**dadurch gekennzeichnet, daß** das Digitalabgleichmittel ein Mittel umfaßt zum Zuführen von Korrekturdaten (150) in Form eines digitalen Wortes, ein Zählermittel (163) zum Empfangen des digitalen Wortes, um somit auf einen Wert entsprechend dem digitalen Wort gesetzt zu werden; ein Mittel (161), das so angeschlossen ist, das es ein Zeitablaufreferenzsignal ($S_P$) vom Frequenzteilermittel empfängt und eine Anzahl von Zählimpulsen ($P_T$) innerhalb der Digitalabgleich-Zeitperiode (T) dem Zählermittel zuführt, wobei die Anzahl der Zählimpulse ($P_T$) gleich dem Wert ist, auf den das Zählermittel gesetzt worden ist, ein Zeitablaufeinstellmittel (170), das so angeschlossen ist, das es den Zählimpuls ($P_T$) empfängt, und mit einer Stufe des Frequenzteilermittels verbunden ist, wodurch im Betrieb die Bereitstellung eines Zählimpulses das Zählermittel dekrementiert und das Zeitablaufeinstellmittel veranlaßt, ein Digitalabgleich-Ausführungssteuersignal ($S_C$) an eine Stufe (120) des Frequenzteilermittels zu liefern, um dessen Logikzustand zu ändern, wobei dann, wenn der Wert des Zählermittels gleich 0 ist, die Korrektur der zeitlichen Verschiebung des Zeitreferenzsignals beendet ist.

**2.** Schaltung nach Anspruch 1, bei der das Digitalabgleichmittel einen Mikrocomputer umfaßt.

**3.** Uhr, die eine Schaltung nach Anspruch 1 oder Anspruch 2 enthält.

**Revendications**

**1.** Circuit d'ajustement numérique pour corriger le décalage temporel d'un signal de référence d'heure ($S_T$) obtenu depuis un signal d'oscillation de base ($f_0$) comprenant:

un moyen d'oscillateur (110) pour générer un signal d'oscillation de base ($f_0$), un moyen de division de fréquence (120, 132, 130) pour recevoir ledit signal oscillant et pour diviser la fréquence du signal oscillant d'une quantité sélectionnée ;
un moyen d'ajustement numérique (140 à 170) comprenant un moyen couplé au moyen de division de fréquence pour sélectivement modifier l'état du moyen de division de fréquence à des intervalles prédéterminés afin de corriger le signal de référence d'heure ($S_T$) à l'intérieur d'une période de temps d'ajustement numérique (T) ;

**caractérisé en ce que** le moyen d'ajustement numérique comprend un moyen pour délivrer des données de correction (150) sous la forme d'un mot numérique, un moyen de comptage (163) pour recevoir ledit mot numérique qui doit être établi à une valeur correspondant au mot numérique, un moyen (161) couplé pour recevoir un signal de référence de cadencement ($S_B$) provenant dudit moyen de division de fréquence et pour délivrer un certain nombre d'impulsions de comptage ($P_T$) à l'intérieur de la période de temps d'ajustement numérique (T) au dit moyen de comptage, le nombre des impulsions de comptage ($P_T$) étant égal à ladite valeur à laquelle ledit moyen de comptage est établi, un moyen d'ajustement de cadencement (170) couplé pour recevoir ladite impulsion de comptage ($P_T$) et couplé à un étage dudit moyen de division de fréquence avec pour effet qu'en fonctionnement la fourniture d'une impulsion de comptage décrémente le moyen de comptage et amène le moyen d'ajustement de cadencement à délivrer un signal de commande d'exécution d'ajustement numérique ($S_C$) à un étage (120) dudit moyen de division de fréquence pour modifier son état logique et lorsque la valeur dudit moyen de comptage est égale à zéro, la correction du décalage temporel dudit signal de référence d'heure est finie.

2. Circuit selon la revendication 1, dans lequel ledit moyen d'ajustement numérique comprend un micro ordinateur.

3. Moyen d'indication de l'heure incluant un circuit selon la revendication 1 ou 2.

FIG.1

EP 0 566 398 B1

FIG.2

F I G.3

EP 0 566 398 B1

FIG.4

FIG.5

FIG. 6

FIG. 7

FIG. 8

EP 0 566 398 B1

EP 0 566 398 B1

FIG. 9

FIG. 10

F I G.11

F I G.12

F I G. 13
PRIOR ART

EP 0 566 398 B1

FIG. 14
PRIOR ART

EP 0 566 398 B1